# EUROPEAN PATENT APPLICATION

(11) **EP 4 703 751 A1**
(43) Date of publication of application: **04.03.2026**
(21) Application number: 24306410.2
(22) Date of filing: 29.08.2024
(51) Int. Cl.: G01R 31/54

(54) **MODULE, SYSTEM AND METHOD FOR DETECTING A STRING FAULT**

(71) Applicant: NXP USA, Inc., Austin TX 78735 (US)
(72) Inventor: d'Esposito, Francesco, 31023 Toulouse Cedex 1 (FR); Tico, Olivier, 31023 Toulouse Cedex 1 (FR); Benoit-Cattin, Theo, 31023 Toulouse Cedex 1 (FR); Royer, Martin, 5656 AG Eindhoven (NL)
(74) Representative: Schmütz, Christian Klaus Johannes

(57) **Abstract**

The present disclosure relates to module comprising a first module terminal for coupling to a first battery node of a battery via a first connecting string, a second module terminal for coupling to a second battery node of the battery via a second connection string, a base module terminal for coupling to a base battery node of the battery via a base connection string, wherein a first module string of the module extends from the first module terminal to a first module node of the module, wherein a second module string of the module extends from the second module terminal to a second module node of the module, wherein a first current source is coupled between the base module terminal and the first module node, wherein a control unit of the module is coupled to the first current source and is configured to control the first current source to activate a generation of a first current in the first module string via the first current source, wherein a first sensor unit of the module is coupled to the first and second module nodes, wherein the first sensor unit is configured to detect a first test voltage between the first module node and the second module node while the first current is flowing, and wherein the control unit is configured to detect a first string fault in the first connection string based on the first test voltage. The present disclosure also relates to a system including the module and a method for the module.

## Description

### TECHNICAL FIELD

The present disclosure relates to a module, a system and a method for the module for detecting a string fault.

### BACKGROUND

There is a wide range of possible applications for batteries. Batteries are used to store electrical energy. For example, batteries can be used for motor vehicles, especially electrically powered motor vehicles, to provide electrical energy. Batteries can also be used in other technical devices to provide electrical energy. The batteries are understood to be electrically rechargeable batteries.

A battery may comprise a plurality of battery cells. Each battery cell may comprise a plurality of individual cells connected in series or in parallel. Each individual cell may be configured to be recharged and/or to store and/or provide electrical energy.

Due to manufacturing tolerances and/or aging of individual cells and/or battery cells, there may be fluctuations in the capacity of the cells and/or fluctuations in the resistance of the cells. To prevent the battery cells from being charged or discharged differently, circuit units can be used for an even electrical charge distribution of all battery cells in a battery. The even charge distribution increases the overall capacity of the battery while protecting the battery cells from adverse conditions. The same or another circuit unit may be used for detecting the cell voltage of the battery cells of the battery.

A battery management system may comprise a plurality of circuit units. Each circuit unit may be configured to be coupled to one or more battery cells. The circuit unit may be used to measure the cell voltages of the battery cells. The same circuit unit or another circuit unit may be used by the battery management system to achieve a uniform electrical charge distribution of all battery cells of the battery. Accidental and/or intentional technical changes can alter the electrical properties of the electrical connection between the circuit units and the battery cells, which in an unfavorable case can cause a shift in the electrical charge distribution of the battery cells of the battery. In an example, if the electrical resistance of an electrical connection increases significantly or the electrical connection is interrupted, this may lead to an inaccurate battery cell voltage measurement result and/or to an unfavorable charge distribution of the battery cells of the battery. Monitoring the electrical connections between the circuit unit and the battery cells can therefore serve to detect any adverse electrical changes in the electrical connections at an early stage.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Aspects of the disclosure are defined in the accompanying claims.

In accordance with a fifth aspect of the present disclosure, a computer program is provided, comprising executable instructions which, when executed by a processing unit, cause the processing unit being configured to carry out the method of the present disclosure and/or one or more embodiments thereof.

### DESCRIPTION OF DRAWINGS

Embodiments of the present disclosure will be described in more detail with reference to the appended drawings. It is to be noted, however, that the appended drawings illustrate only typical embodiments of the present disclosure and are therefore not to be considered limiting of its scope, such that other equally effective embodiments may be implemented. Advantages of the subject matter claimed will become apparent to those skilled in the art upon reading this description in conjunction with the accompanying drawings, in which like reference numerals have been used to designate like elements, and in which:
Figure 1 shows a simplified block diagram of an example of the module.
Figure 2 shows a simplified block diagram of another example of the module.
Figure 3 shows an example of a simplified phase chart.
Figure 4 shows an example of a simplified flow chart.

### DESCRIPTION OF EMBODIMENTS

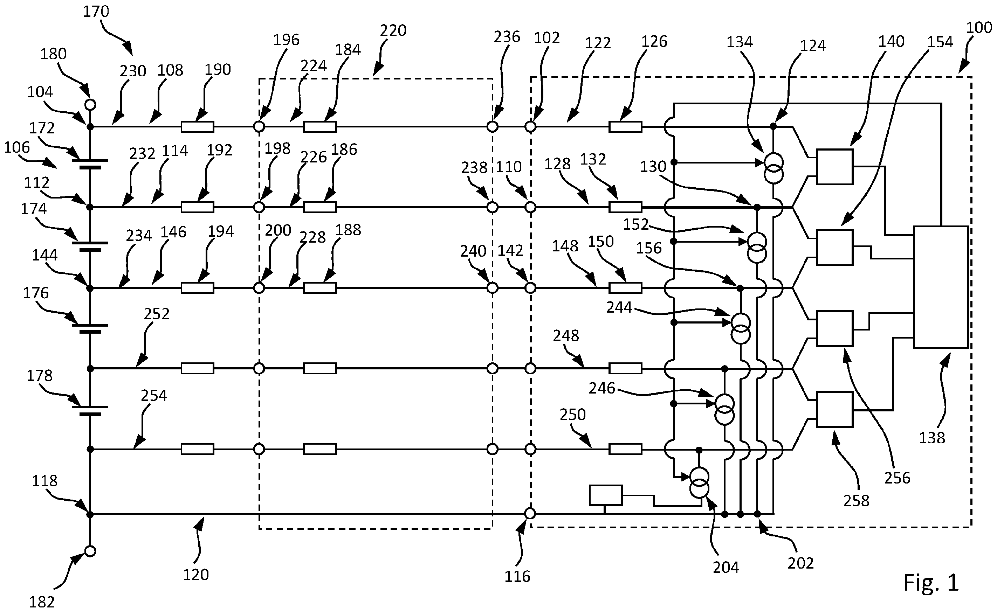

In Figure 1, an example of a battery 106 is shown schematically. The battery 106 comprises a plurality of battery cells 172, 174, 176, 178, which may be connected in series. In the respective series circuit, a second battery cell 174 can be coupled behind a first battery cell 172, a third battery cell 176 can be coupled behind the second battery cell 174, and a fourth battery cell 178 can be coupled behind the third battery cell 176. The series circuit may further comprise additional battery cells (not shown). In an example, the series circuit of battery cells 172, 174, 176, 178 extends from a first battery terminal 180 to a second battery terminal 182. The series circuit may further comprise a plurality of battery nodes 104, 112, 144, 118. A first battery node 104 may be disposed between the first battery terminal 180 and the first battery cell 172. A second battery node 112 may be disposed between the first battery cell 172 and the second battery cell 174. A third battery node 144 may be disposed between the second battery cell 174 and the third battery cell 176. Another battery node, also referred to as the base battery node 118, may be disposed between the fourth battery cell 178 and the second battery terminal 182. Further battery cells (not shown) may be integrated into the series circuit between the third battery cell 176 and the fourth battery cell 178.

Figure 1 also shows an example of a simplified, schematically illustrated circuit unit 220. The circuit unit 220 comprises a plurality of circuit terminals 196, 198, 200. In addition, the circuit unit 220 may comprise a plurality of strings, also referred to as circuit strings 224, 226, 228. A first circuit string 224 may be coupled to the first circuit terminal 196. A second circuit string 226 may be coupled to a second circuit terminal 198. A third circuit string 228 may be coupled to a third circuit terminal 200. An impedance, also referred to as a sixth impedance 184, may be integrated into the first circuit string 224. Further electrical components may be integrated into the first circuit string 224, which may form a low pass filter, for example. Another impedance, also referred to as the seventh impedance 186, may be integrated into the second circuit string 226. Further electrical components may be integrated into the second circuit string 226, which may, for example, form a further low-pass filter. A further impedance, which may also be referred to as the eighth impedance 188, may be integrated into the third circuit string 228. Further electrical components may be integrated into the third circuit string 228, which may, for example, form a further low-pass filter.

The circuit unit 220 may be coupled to battery nodes 104, 112, 144 of the battery 106 via the circuit terminals 196, 198, 200. In an example, the first circuit terminal 196 may be coupled to the first battery node 104 of the battery 106 via a first coupling string 230. The first coupling string 230 may comprise an electrical resistance schematically represented by the ninth impedance 190. The second circuit terminal 198 may be coupled to the second battery node 112 of the battery via a second coupling string 232. The second coupling string 232 may comprise an electrical resistance schematically represented by the tenth impedance 192. The third circuit terminal 200 may be coupled to the third battery node 144 of the battery 106 via a third coupling string 234. The third coupling string 234 may comprise an electrical resistance schematically represented by the eleventh impedance 194.

In an example, the circuit unit 220 may comprise a plurality of test terminals 236, 238, 240. The first circuit string 224 may extend from a first test terminal 236 to the first circuit terminal 196. The second circuit string 226 may extend from a second test terminal 238 to the second circuit terminal 198. The third circuit string 228 may extend from a third test terminal 240 to the third circuit terminal 200.

To allow an accurate voltage measurement of the cell voltages of the battery cells 172, 174, 176, 178 of the battery 106 via the circuit unit 220, none of the coupling strings 230, 232, 234 and/or none of the circuit strings 224, 226, 228 should be faulty. A fault in one of the strings may be, for example, if the respective string comprises a too high electrical resistance and/or if the respective string comprises an interruption. A fault in a string may also be referred to as a string fault.

The circuit unit 220 may also be used for achieving an even charge distribution across the battery cells 172, 174, 176, 178 of the battery 106. Against this background, it may also be of interest that none of the coupling strings 230, 232, 234 and/or none of the circuit strings 224, 226, 228 should be faulty.

Figure 1 also schematically illustrates an example of a module 100. The module 100 may be provided as a device and/or as a part of an integrated circuit (IC). The module 100 may be used to detect a fault in a string 108. The string 108 is also referred to as a first connecting string 108. In an example, a string may be understood to be an electrical connection, which may in particular comprise electrical elements, such as an electrical impedance and/or other elements. The string may extend between two locations. The first connection string 108 may be formed by the first coupling string 230, by the first circuit string 224, or by a series connection of both the first circuit string 224 and the first coupling string 230.

The module 100 comprises a plurality of module terminals 102, 110, 142, 116. A first module terminal 102 of the module 100 is used to couple the module 100 to the first battery node 104 of the battery 106 via the first connection string 108. In an example, the first connection string 108 may extend from the first module terminal 102 to the first battery node 104. An electrical connection can be established between the first module terminal 102 and the first battery node 104 through the first connection string 108.

A second module terminal 110 of the module 100 is used to couple the module 100 to the second battery node 112 of the battery 106 via another connection string 114, which is referred to as the second connection string 114. The second connection string 114 can be formed by the second coupling string 232, by the second circuit string 226, or by a series connection of both, the second circuit string 226 and the second coupling string 232. An electrical connection between the second module terminal 110 and the second battery node 112 can be established by the second connection string 114.

Another module terminal 116 of the module 100 may also be referred to as the base module terminal 116. The base module terminal 116 of the module 100 is used to couple the module 100 to a further battery node 118, which is also referred to as the base battery node 118, of the battery 106 via a further connection string 120, which is also referred to as the base connection string 120. The base battery node 118 may be disposed between the second battery terminal 182 and the battery cell 178 of the battery 106 that is disposed closest to the second battery terminal 182 in the series connection of the battery cells 172-178. In an example, the base battery node 118 is disposed between the second battery terminal 182 and the fourth battery cell 178.

The module 100 also comprises a first module string 122 extending from the first module terminal 102 to a first node 124 of the module 100, wherein the first node 124 is also referred to as the first module node 124. A first impedance 126 is integrated into the first module string 122. In an example, the first impedance 126 may be configured as a component of the first module string 122. The first impedance 126 may comprise a predefined electrical resistance value. The first module node 124 may be formed by an end of the first module string 122.

The module 100 also comprises a second module string 128 extending from the second module terminal 110 to a second node 130 of the module 100, wherein the second node 130 is also referred to as the second module node 130. A second impedance 132 is integrated into the second module string 128. In an example, the second impedance 132 may be configured as a component of the second module string 128. The second impedance 132 may comprise a predefined electrical resistance value. The second module node 130 may be formed by an end of the second module string 128.

The module 100 further comprises a current source 134, also referred to as a first current source 134. A current source may be understood as a unit being configured to create an electrical current. The first current source 134 is coupled between the base module terminal 116 of the module 100 and the first module node 124 of the first module string 122. The first current source 134 may be configured as a controllable current source. In an example, the first current source may be configured to be activated or deactivated. If the first current source 134 is activated, the first current source 134 may be configured to generate a first current. The current value of the first current may be predefined. If the first current source 134 is deactivated, the first current source 134 may be configured to not generate a current. As an effect, the first current source 134 may be controlled to change between an activated state and a deactivated state, or vice versa. In an example, the first current source 134 generates the first current only in the activated state.

The module 100 further comprises a control unit 138. The control unit 138 is coupled to the first current source 134 to control the first current source 134. The control unit 138 is configured to control the first current source 134 to activate a generation of the first current in the first module string 122 via the first current source 134. In an example, the first current source 134 is controlled by the control unit 138 to activate the first current source 134. In the activated state, the first current source 134 generates the first current. The first current source 134 is coupled between the base module terminal 116 and the first module node 124 of the first module string 122, such that the first current generated by the first current source 134 flows through the first module string 122.

The module 100 also comprises a sensor unit 140, also referred to as a first sensor unit 140. The first sensor unit 140 is coupled to the first module node 124 and to the second module node 130. The first sensor unit 140 is configured to detect an electrical voltage, also referred to as a first test voltage, between the first module node 124 and the second module node 130 as the first current flows through the first module string 122.

In an example, the first sensor unit 140 is coupled to the control unit 138 via a signal line such that a sensor signal from the first sensor unit 140 can be transmitted to the control unit 138 via the signal line. The sensor signal generated by the first sensor unit 140 can represent the first test voltage.

In an example, the control unit 138 is coupled to the first current source 134 via a control line such that a control signal from the control unit 138 can be transmitted to the first current source 134 via the control line. The control signal may represent an instruction for the first current source 134 to activate or deactivate the first current source 134. As an effect, the control unit 138 may control the first current source 134 via the control signal. The control unit 138 may detect the first test voltage via the sensor signal from the first sensor unit 140 after and/or while the first current source 134 is activated by the control unit 138. Subsequently, the control unit 138 may control the first current source 134 such that the first current source 134 is deactivated.

The control unit 138 may be configured to detect a fault, also referred to as a first string fault, in the first connection string 108 based on the first test voltage. In particular, the first string fault may relate to a high electrical resistance of the first connection string 108 and/or an interruption of the first connection string 108.

In an example, the module 100 may be coupled to the battery 106 via the connection strings 108, 114, 146, 120. The first connection string 108 may extend from the first module terminal 102 to the first battery node 104. The second connection string 114 may extend from the second module terminal 110 to the second battery node 112. The first battery cell 172 may be coupled between the first battery node 104 and the second battery node 112 such that an electrical voltage of the first battery cell 172 drops between the first and second battery nodes 104, 112. The voltage of the first battery cell 172 may also be referred to as the first cell voltage. The base connection string 120 may extend from the base module terminal 116 to the base battery node 118.

In an example, the control unit 138 may control the first current source 134 such that the first current source 134 is activated and, as an effect, the first current flows through the first module string 122. Due to the first current, a first string voltage drops across the first module string 122 and the first connection string 108. The first test voltage, which can be detected by the first sensor unit 140, depends on the first string voltage. The greater the electrical resistance of one of the impedances 190, 184, the greater the first string voltage and the lower the first test voltage. In an example, if the electrical resistance of one impedance 190, 184 of the first connection string 108 is too large, in particular due to damage to the first coupling string 230, then the first test voltage will comprise a value that is too small, indicating the first string fault in the first connection string 108. As a result, the control unit 138 may be configured to detect whether the first string fault exists based on the first test voltage.

Via the module 100, it can be detected whether a first string fault exists in the first connection string 108. The information that a first string fault exists in the first connection string 108 can be very valuable. This is because if the first string fault actually occurs, action may be required to repair it. If the first current is caused at the first module string 122 via the module 100, and no string fault is detected in the first connection string 108 based on the first test voltage, it can be assumed in an example that the first connection string 108 can also be used reliably perform a voltage measurements and/or other tasks with regard to the battery cells 172-178.

The module 100 provides the advantage that at least one connection string 108 can be tested first to ensure that the connection string 108 can subsequently be used reliably.

The use of the first current source 134 to test a fault-free condition of the first connection string 108 also provides the advantage that little space is consumed by the first current source 134. The first current source 134 may be realized by a simple and compact circuit.

In an example, the first coupling string 230 comprises the ninth impedance 190. The ninth impedance 190 may represent a line resistance of the first coupling string 230. In particular, the ninth impedance 190 of the first coupling string 230 may be between 0.1 Ohm and 5 Ohm. In an example, the first circuit string 224 comprises the sixth impedance 184. The sixth impedance 184 may comprise a predefined electrical resistance value, for example between 10 Ohms and 100 Ohms. The first module string 122 has the first impedance 126, which in an example comprises a predefined, electrical resistance value that is, for example, between 500 Ohms and 2000 Ohms, in particular 1000 Ohms. The first impedance 126 may be greater than the sixth impedance 184 and/or ninth impedance 190. In an example, the first impedance 126 is at least twice as large as the sum of the resistance values of the sixth and ninth impedances 184, 190. As an effect, the module 100 may be robust to small variations in the resistance values of the sixth and ninth impedances 184, 190. On the other hand, if a fault occurs in the first connection string 108 that results in a large change in the electrical impedance of the first connection string 108, then the resulting change in the first test voltage may result in detection of the first string fault by the control unit 138.

In an example, the circuit unit 220 may be coupled between the battery 106 and the module 100 such that the circuit unit 220 forms at least a part of the first connection string 108, the second connection string 114, the third connection string 146, and/or the base connection string 120.

The first circuit string 224 may extend from the first test terminal 236 to the first circuit terminal 196. The first circuit string 224 may form a part of the first connection string 108. The first connection string 108 may extend from the first module terminal 102 to the first battery node 104. As an effect, the first connection string 108 may extend through the circuit unit 220, where the first circuit string 224 may form a section of the first connection string 108. The first module terminal 102 may be coupled to and/or form the first test terminal 236.

The second circuit string 226 may extend from the second test terminal 238 to the second circuit terminal 198. The second circuit string 226 may form a part of the second connection string 114. The second connection string 114 may extend from the second module terminal 110 to the second battery node 112. As an effect, the second connection string 114 may extend through the circuit unit 220, where the second circuit string 226 may form a section of the second connection string 114. The second module terminal 110 may be coupled to and/or form the second test terminal 238.

The third circuit string 228 may extend from the third test terminal 240 to the third circuit terminal 200. The third circuit string 228 may form a part of the third connection string 146. The third connection string 146 may extend from the third module terminal 142 to the third battery node 144. As an effect, the third connection string 146 may extend through the circuit unit 220, where the third circuit string 228 may form a section of the third connection string 146. The third module terminal 142 may be coupled to and/or form the third test terminal 240.

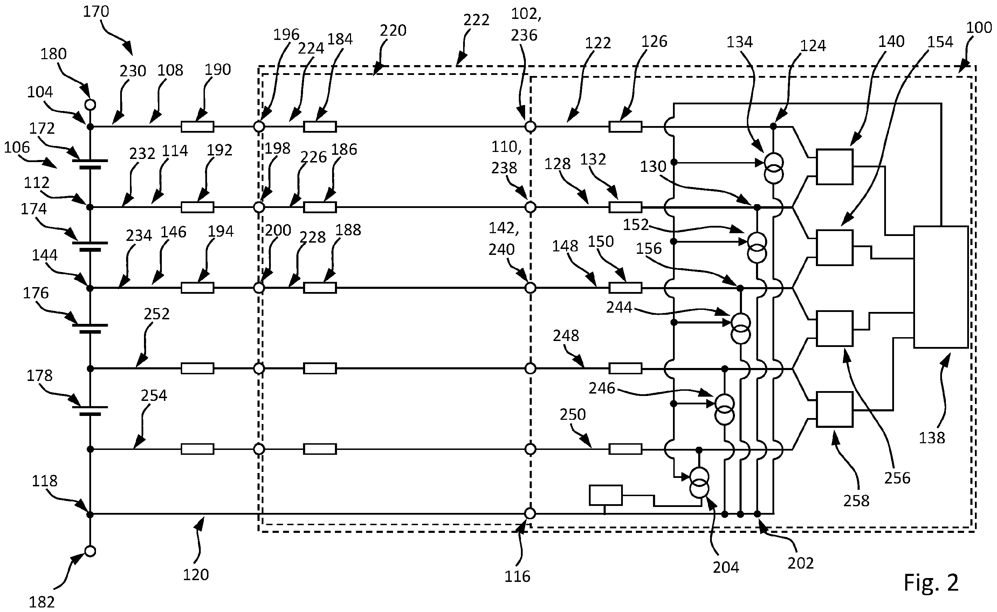

Figure 1 schematically illustrates an example of the module 100. The module 100 may be coupled to the battery 106 via the circuit unit 220 and the coupling strings 230-234. In an example, the module 100 may be connected to the circuit unit 220. In another example, the module 100 and the circuit unit 220 may be integrally formed and/or fixedly connected to each other. In an example, the module 100 and the circuit unit 220 may each form a part of a single device 222, also referred to as a circuit unit device 222. The device 222 may be a printed circuit board (PCB) including the module 100 and the circuit unit 220. The circuit unit 220 may be a circuit provided at the printed circuit board. The device 222 may include an integrated circuit (IC), which may include the module 100. As an effect, the module 100 may be a part of the integrated circuit and/or may be formed by the integrated circuit. An example of the device 222 is shown schematically in Figure 2.

The preceding explanations, potential features, technical effects and/or advantages as explained in connection with Figure 1 may apply in an analogous manner to Figure 2, and vice versa.

In an example, a terminal may be considered an interface, a pin or a node. With respect to the example of the device 222 schematically illustrated in Fig. 2, both, the module 100 and the circuit unit 220, may be included by the device 222. The device 222 may be configured as a printed circuit board (PCB). The module 100 may be included by an integrated circuit (IC) of the device. In an example, the first module terminal 102 and the first test terminal 236 may be considered as a single terminal, which may be configured as a node of the device 222, wherein said node may be referred to as the first module node. As an effect, both, first module terminal 102 and the first test terminal 236 may be provided and/or configured by said single module node of the printed circuit board. The first module node may be provided at an interface section between the integrated circuit (and/or the module 100) and the circuit unit 220. The preceding explanations provided in relation to the first module terminal 102 and the first test terminal 236 may apply in an analogous manner to the respective other module terminals 110, 142 and the corresponding test terminals 238, 240. In an example, the second module terminal 110 and the second test terminal 238 may be considered as a single terminal, which may be configured as a node of the device 222, wherein said node may be referred to as the second module node. As an effect, both, second module terminal 110 and the second test terminal 238 may be provided and/or configured by said single second module node of the printed circuit board. The second module node may be provided at an interface section between the integrated circuit (and/or the module 100) and the circuit unit 220. In an example, the third module terminal 142 and the third test terminal 240 may be considered as a single terminal, which may be configured as a node of the device 222, wherein said node may be referred to as the third module node. As an effect, both, third module terminal 142 and the third test terminal 240 may be provided and/or configured by said single module node of the printed circuit board. The third module node may be provided at an interface section between the integrated circuit (and/or the module 100) and the circuit unit 220.

In an example, the control unit 138 is configured to control the first current source 134 to either activate or deactivate a generation of the first current in the first module string 122 via the first current source 134. It was previously explained that the first sensor unit 140 is configured to detect the first test voltage between the first and second module nodes 124, 130 while the first current is flowing. In an example, the first sensor unit 140 is further configured to detect another voltage, referred to as the first open circuit voltage, between the first module node 124 and the second module node 130 while the first current is not flowing. In an example, the first sensor unit 140 may detect the first open circuit voltage between the first and second module nodes 124, 130 while the first current source 134 is deactivated.

If the first current source 134 is activated so that the first current flows through the first module string 122 and the first connecting string 108, then the first current causes a first string voltage to drop across the first module string 122 and the first connecting string 108. If the first current source 134 is deactivated, then the first string voltage does not drop. The resistance values of the first impedance 126, the sixth impedance 184 and the ninth impedance 190 should usually be known, so that the first string voltage may be determined in advance, in particular based on said determination. The expected first string voltage can therefore be known in advance. Based on this knowledge, it is also to be expected that the first test voltage is less than the first open circuit voltage. It may also be expected that the difference between the two voltages should at least approximately correspond to the first string voltage. The first control unit 138 may therefore be configured to detect the first string fault based on the first open circuit voltage and the first test voltage. If the difference between the first open circuit voltage and the first test voltage deviates by more than a predefined value from the expected first string voltage, then this deviation may indicate the first string fault. In a corresponding manner, the control unit 138 can be configured to detect the first string fault.

In an example, the control unit 138 may be configured to first activate the first current source 134 to detect via the first sensor unit 140, while the first current source 130 is activated, the first test voltage. The control unit 138 may further be configured to subsequently deactivate the first current source 130 to detect via the first sensor unit 140, while the first current source 134 is deactivated, the first open circuit voltage. The control unit 138 may further be configured, after the first test voltage and the first open circuit voltage are detected, to check whether the first string fault exists, in particular based on both voltages.

It has previously been explained that the first string voltage can be determined in advance based on knowledge of the impedance 126, 184, 190 and the knowledge of the expected current value of the first current. The first string voltage may be a base and/or a reference value for an expected difference between the first open circuit voltage and the first test voltage.

In an example, the control unit 138 is configured to detect the first string fault based on a first differential voltage representing the actual difference between the first open circuit voltage and the first test voltage. As an effect, the control unit 138 may be configured to detect the first string fault based on the first open circuit voltage and the first test voltage, because both voltage values, namely the first open circuit voltage and the first test voltage, are to be taken into account to determine the first differential voltage. In an example, the control unit 138 may be configured to first determine the first differential voltage from the actual difference between the first open circuit voltage and the first test voltage, and to then determine whether the first string fault is present based on the first differential voltage.

As an effect, the control unit 138 may be configured to detect the first string fault based on the first open circuit voltage and the first test voltage, because both voltage values, namely the first open circuit voltage and the first test voltage, are to be taken into account to determine the first differential voltage.

In an example, the control unit 138 may be configured to check whether the first differential voltage is outside a predefined first reference range. The first reference range may, for example, be defined using the expected first string voltage. For example, the first reference range may be between 80% of the first string voltage and 120% of the expected first string voltage. In an example, the control unit may be configured to detect the first string fault in response to the first differential voltage being outside the first reference range. The first differential voltage is outside the first reference range if the first differential voltage is less than a lower limit of the first reference range or greater than an upper limit of the first reference range. In the example given above, the control unit 138 may be configured to detect the first string fault in response to the first differential voltage being less than the lower limit of the first reference range or greater than the upper limit of the first reference range. Previously, an example was given in which the first reference range is between 80% and 120% of the expected first string voltage. In this example, if the first differential voltage is about 90% of the expected first string voltage, then the control unit 138 will not detect the first string fault. However, in another example if the first differential voltage is about 70% of the first string voltage, then the control unit 138 will detect the first string fault. The percentage values mentioned above are to be understood as examples only and can be adapted to the respective circumstances.

From the foregoing explanations, it may be derived that the module 100 can be used in a simple, efficient and space-saving manner to determine whether a first connection string 108 can be reliably used in particular for an accurate cell voltage measurement purpose and/or for other purposes, for example to achieve an even distribution of the amount of charge across the battery cells 172-178. If the first string fault is determined to be present via the module 100, as a consequence a repair of the system 170 may take place.

In an example, the IC of the device 222 may comprise a plurality of switching units (not shown). A first switching unit may be coupled between the first module terminal 102 and the second module terminal 110. A second switching unit may be coupled between the second module terminal 110 and the third module terminal 142. Further switching units may be coupled between further sets of module terminals.

In an example, the IC may be configured to control the switching units to achieve an even distribution of the amount of charge across the battery cells 172, 174, 176, 178. In an example, the IC may be configured to control the first switching unit such that the first switching unit establishes a conductive connection for a certain time between the first and second module terminal 102, 110 such that a certain amount of charge remains to be stored by the first battery cell 172. Further, the IC may be configured to control the second switching unit such that the second switching unit establishes a conductive connection for a certain time between the second and third module terminals 110, 142 such that a predetermined amount of charge remains to be stored by the second battery cell 174. The IC may be configured to control the switching units such that the same amount of charge is stored by each of the battery cells 172-178. The preceding explanation of an example of the IC is intended as only one of many possibilities for balancing the charge of the battery cells 172-178. Other circuit designs of the IC may also be provided which allow charge distribution among the battery cells 172-178.

As previously mentioned, the module 100 may comprise the third module terminal 142. The third module terminal 142 may be used to couple the module 100 to the third battery node 144 of the battery 106 via the third connection string 146. The third connection string 146 may be formed by the third coupling string 234, by the third circuit string 228, or by a series connection of both the third circuit string 228 and the third coupling string 234. An electrical connection between the third module terminal 142 and the third battery node 144 may be established by the third connection string 146.

The module 100 may further comprise a third module string 148 extending from the third module terminal 142 to a third node 156, wherein the third node 156 is also referred to as a third module node 156. A third impedance 150 may be integrated into the third module string 148. In an example, the third impedance 150 may be formed from a component of the third module string 148. The third impedance 150 may comprise a predefined electrical resistance value. The third module node 156 may be formed by an end of the third module string 148.

The module 100 may further comprise another current source 152, also referred to as a second current source 152. The second current source 152 may be coupled between the base module terminal 116 of the module 100 and the second module node 130 of the second module string 128. The second current source 152 may be configured as a controllable current source. In an example, the second current source 152 may be configured to be activated or deactivated. If the second current source 152 is activated, the second current source 152 may be configured to generate a second current. The current value of the second current may be predefined. If the second current source 152 is deactivated, the second current source 152 may be configured to not generate a current. As an effect, the second current source 152 may be controlled to change between an activated state and a deactivated state, or vice versa. In an example, the second current source 152 may generate the second current only in the activated state.

The control unit 138 may be coupled to the second current source 152 to control the second current source 152. The control unit 138 may be configured to control the second current source 152 to activate a generation of the second current in the second module string 128 via the second current source 152. In an example, the second current source 152 is controlled by the control unit 138 to activate the second current source 152. In the activated state, the second current source 152 can generate the second current. The second current source 152 may be coupled between the base module terminal 116 and the second module node 130 of the second module string 128, such that the second current generated by the second current source 152 also flows through the second module string 128.

The module 100 may further comprise another sensor unit 154, also referred to as the second sensor unit 154. The second sensor unit 154 may be coupled to the second module node 130 and to the third module node 156. The second sensor unit 154 may be configured to detect an electrical voltage, also referred to as a second test voltage, between the second module node 130 and the third module node 156 while the second current is flowing through the second module string 128.

In an example, the second sensor unit 154 is coupled to the control unit 138 via a (further) signal line such that a sensor signal from the second sensor unit 154 can be transmitted to the control unit via the signal line. The sensor signal generated by the second sensor unit 150 can represent the second test voltage.

In an example, the control unit 138 is coupled to the second current source 152 via a (in particular further) control line, so that a second control signal of the control unit 138 can be transmitted to the second current source 152 via the control line. The second control signal may represent an instruction for the second current source 152 to activate or deactivate the second current source 152. As an effect, in an example, the control unit 138 may control the second current source 152 via the second control signal. In an example, the control unit 138 may detect the second test voltage via the sensor signal from the second sensor unit 154 after and while the second current source 152 is activated by the control unit 138. Subsequently, in an example, the control unit 138 may control the second current source 152 such that the second current source 152 is deactivated.

In an example, the control unit 138 may be configured to detect a fault in the second connection string 114, also referred to as a second string fault, based on the second test voltage. In particular, the second string fault may relate to a too high electrical resistance of the second connection string 114 and/or an interruption of the second connection string 114.

In an example, the second battery cell 174 may be configured to be coupled between the second battery node 112 and the third battery node 144 such that an electrical voltage of the second battery cell 174 drops between the second and third battery nodes 112, 144. The voltage of the second battery cell 174 may also be referred to as the second cell voltage.

In an example, the control unit 138 may control the second current source 152 such that the second current source 152 is activated and, as an effect, the second current flows through the second module string 128. Due to the second current, a second string voltage drops across the second module string 128 and the second connection string 114. The second test voltage, that can be detected by the second sensor unit 154, depends on the second string voltage. The greater the electrical resistance of one of the impedances 192, 186, the greater the second string voltage and the lower the second test voltage. In an example, if the electrical resistance of one of the impedances 192, 186 of the second connection string 114 is too high, in particular due to damage to the second connection string 114, then the second test voltage will have a value that is too small, indicating the second string fault in the connection string 114. The control unit 138 may be configured to detect whether the second string fault exists based on the second test voltage.

As explained, it may be detected via the module 100 whether a second string fault exists in the second connection string 114. The information that a second string fault exists in the second connection string 114 can be very valuable. This is because if the second string fault actually occurs, action may be required to repair it. If, via the module 100, the second current is caused throuhg the second module string 128, and no second string fault is detected at the second connection string 114 based on the second test voltage, it may be assumed in an example that the second connection string 114 can also be used reliably perform a voltage measurements and/or other tasks with regard to the battery cells 172-178.

The module 100 may provide the advantage, after testing the first connection string 108, the second connection string 114 and in particular further connection strings 146, that the connection strings 108, 114, 146 may subsequently be used reliably.

The use of the second current source 152 to test a fault-free condition of the second connection string 114 also has the advantage of using a small amount of space by the second current source 152. The second current source 152 may be realized by a simple and compact circuit.

In an example, the second and third connecting strings 114, 146 and/or any further connection string may each be configured analogously to the first connecting string 108. For the second and third connection strings 114, 146, reference is preferably made to the preceding explanations, potential features, technical effects and advantages in an analogous manner as already explained for the first connection string 108.

In an example, the second and third module strings 128, 148 may each be configured analogously to the first module string 122. For the second and third module strings 128, 148, reference is preferably made to the preceding explanations, potential features, technical effects and advantages in an analogous manner as already explained for the first module string 122.

In an example, the control unit 138 may be configured to control the second current source 152 to either activate or deactivate a generation of the second current in the second module string 128 via the second current source 152. It was previously explained that the second sensor unit 154 may be configured to detect the second test voltage between the second and third module nodes 130, 156 while the second current is flowing. In an example, the second sensor unit 154 is configured to detect another voltage, referred to as the second open circuit voltage, between the second module node 130 and the third module node 156 while the second current is not flowing.

In an example, if the second current source 152 is activated so that the second current flows through the second module string 128 and the second connection string 114. Due to the second current, the second string voltage drops across the second module string 128 and the second connection string 114. If the second current source is deactivated, then the second string voltage does not drop. The resistance values of the second impedance 132, the seventh impedance 186 and the tenth impedance 192 should usually be known, so that the second string voltage can be determined in advance. The expected second string voltage can therefore be known in advance, in particular based on said determination. From this knowledge, it is also to be expected that the second test voltage is less than the second open circuit voltage. It may also be expected that a difference between the two voltages should may correspond at least approximately to the expected second string voltage. The control unit 138 may be configured to detect the second string fault based on the second open circuit voltage and the second test voltage. If the difference between the second open circuit voltage and the second test voltage deviates by more than a predefined value from the expected second string voltage, then this deviation may indicate the second string fault. Accordingly, the control unit 138 may be configured to detect the second string fault.

In an example, the control unit 138 may be configured, in particular after the first current source 134 has been deactivated, to activate the second current source 152 to detect the second test voltage via the second sensor unit 154 while the second current source 152 is activated. The control unit 138 may be configured to subsequently deactivate the second current source 152 to detect the second open circuit voltage via the second sensor unit 154 while the second current source 152 is deactivated. The control unit 138 may further be configured to check whether the second string fault exists after the second test voltage and the second open circuit voltage have been detected.

It was previously explained that the second string voltage can be determined in advance as expected second string voltage based on knowledge of the impedances 132, 186, 192 190 and the knowledge of the expected current value of the second current. The expected second string voltage may be a base and/or indicative value for an expected difference between the second open circuit voltage and the second test voltage.

In an example, the second control unit 138 may be configured to detect the second string fault based on a second differential voltage representing the difference between the second open circuit voltage and the second test voltage. As an effect, the control unit 138 may further detect the second string fault based on the second open circuit voltage and the second test voltage, because both voltage values, namely the second open circuit voltage and the second test voltage, are to be taken into account to determine the second differential voltage. In an example, the control unit 138 may be configured to first determine the second differential voltage from the actual difference between the second open circuit voltage and the second test voltage, and to then determine whether the second string fault is present based on the second differential voltage.

In an example, the control unit 138 may be configured to check whether the second differential voltage is outside a predefined second reference range. The second reference range may, for example, be defined using the expected second string voltage. For example, the second reference range can be between 80% of the expected second string voltage and 120% of the expected second string voltage. In an example, the control unit 138 may be configured to detect the second string fault in response to the second differential voltage being outside the second reference range. The second differential voltage is outside the second reference range if the second differential voltage is less than a lower limit of the second reference range or greater than an upper limit of the second reference range. For the purposes of the previous example, the control unit 138 may be configured to detect the second string fault in response to the second differential voltage being less than the lower limit of the second reference range or greater than the upper limit of the second reference range. Previously, an example was given in which the second reference range is between 80% and 120% of the second string voltage. In this example, if the second differential voltage is about 90% of the second string voltage, then the control unit 138 will not detect the second string fault. However, if the second differential voltage is about 70 % or 130 % of the second string voltage, then the control unit 138 will detect the second string fault. The percentage values mentioned are to be understood as examples and can be adapted to the respective circumstances.

From the foregoing explanations, it may be derived that the module 100 can be used to determine in a simple, efficient and space-saving manner whether a second connection string 114 can be reliably used, in particular for further measurements and/or for balancing purpose.

Previously, it was explained that the first test voltage may be measured via the first sensor unit 140 while the first current is caused in the first connection string 108 via the first current source 134 in the first module string 122. The first test voltage may be used by the control unit 138 to determine whether a first string fault exists in the first connection string 108. The second current source 152 may cause a second current through the second module string 128 and the second connection string 114. For detecting the first test voltage, it is advantageous if the second current source 152 does not cause the second current while the first sensor unit 140 detects the first test voltage. This is because the second current can have an influence on the second test voltage. This influence can be avoided.

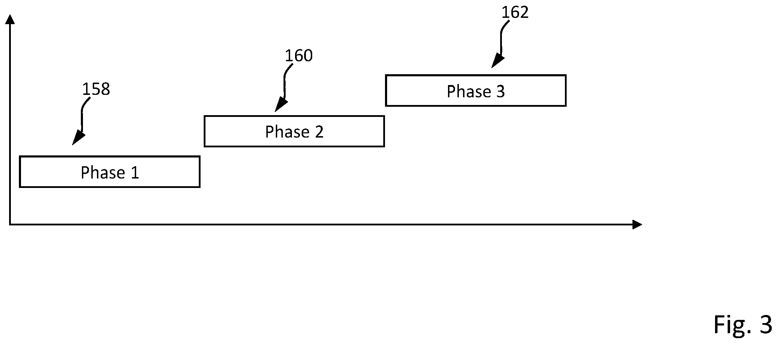

In an example, the control unit 138 may be configured to control the current sources 134, 152 in a plurality of successive phases 158, 160, 162. In Figure 3, an example of the plurality of phases 128, 160, 162 are schematically shown in blocks. In each of the phases 158, 160, 162, multiple steps may be performed by the control unit 138. The advantage of organizing the multiple phases 158, 160, 162 is that the testing of the connecting strings 108, 114, 146 can be performed precisely without the tests negatively affecting each other. In an example, the phases 158, 160, 162 may be performed sequentially. In an example, the phases 158, 160, 162 may be performed in the following order: first phase 158, second phase 160, and optionally third phase 162.

In an example, the control unit 138 is configured to, in a first phase 158, control the first current source 134 to activate generation of the first current in the first module string 122 via the first current source 134. In an example, the first current source 134 is controlled by the control unit 138 such that the first current source 134 is activated during an entire first phase 158 or during a part of the first phase 158. Further, the control unit 138 may be configured to control the second current source 152 during the first phase to deactivate generation of the second current in the second module string 128 via the second current source 152. In an example, the second current source 152 is controlled by the control unit 138 such that the second current source 152 is deactivated at least if the first current source 134 is activated. In an example, the control unit 138 may be configured to deactivate the second current source 152 during the entire first phase 158 such that no second current is caused by the second current source 152 during the entire first phase 158. Deactivating the second current source 152 during the first phase 158 offers the advantage that the first test voltage can be determined without the influence of the second current of the second current source 152. Based on the first test voltage, a possible first string fault can therefore be detected reliably.

In an example, the second phase 160 follows the first phase 158. The second phase 160 may directly follow the first phase 158. Alternatively, there may also be a pause, in particular a short pause, between the first phase 158 and the second phase 160.

In an example, the control unit 138 is configured to control second current source 152 in the second phase 160 such as to activate the generation of the second current in the second module string 128 via the second current source 152. In an example, the second current source 152 is controlled by the control unit 138 such that the second current source 152 is activated during the entire second phase 160 or a part of the second phase 160. Further, the control unit 138 may be configured to control the first current source 134 during the second phase to deactivate generation of the first current in the first module string 122 via the first current source 134. In an example, the first current source 134 is controlled by the control unit 138 such that the first current source 134 is deactivated at least if the second current source 152 is activated. In an example, the control unit 138 may be configured to deactivate the first current source 134 throughout the second phase 160 such that no first current is caused by the first current source 134 throughout the second phase 160. Deactivating the first current source 134 during the second phase 160 provides the advantage that the second test voltage can be determined without being influenced by the first current from the first current source 134. Based on the second test voltage, a possible second string fault can therefore be detected reliably.

It has already been explained above that the first test voltage and the first open-circuit voltage can be used to detect the first string fault. In addition, it has already been explained that the second test voltage and the second open-circuit voltage can be used to detect the second string fault. The current source 134, 152 should be deactivated for determining the first and second open circuit voltages. Against this background, it is advantageous if the first and second open circuit voltages are detected in a third phase 162. In an example, the third phase 162 follows the second phase 160. The third phase 162 may directly follow the second phase 160. Alternatively, there may also be a pause, in particular a small pause, between the second phase 160 and the third phase 162. Furthermore, it is in principle possible for the first phase 158, the second phase 160, and the third phase 162 to be performed in a different order than that shown schematically in Figure 3. In an example, the second phase 160 may be performed before the first phase 158. In another example, the third phase 162 may be performed before the second phase 160 or before the first phase 158. Preferably, there is no temporal overlap between the phases. 158, 160, 162.

In an example, the control unit 138 is configured to control, in the third phase 162, the first current source 134 such as to deactivate generation of the first current in the first module string 122 via the first current source 134. Further, the control unit 138 may be configured to control, in the third phase 162, the second current source 152 to deactivate generation of the second current to the second module string 128 via the second current source 152. In an example, the first sensor unit 140 is configured to detect the first open circuit voltage in the third phase 162. The control unit 138 may be configured to deactivate the first and second current sources 134, 152 at least if the first sensor unit 140 detects the first open circuit voltage. The second sensor unit 154 may be configured to detect the second open circuit voltage in the third phase 162. The control unit 138 may be configured to deactivate the first and second current sources 134, 152 of the if the second sensor unit 154 detects the second open circuit voltage.

As can be seen from Figures 1 and 2, the first module string 122, the first connection string 108, the first current source 134, and the first sensor unit 140 may be provided in an analogous manner multiple times, for example by the third module string 148, the third connection string 146, the third current source 244, and the third sensor unit 256. The preceding explanations, potential features, technical effects, and advantages as explained in connection with the first module string 122, the first connection string 108, the first current source 134, and the first sensor unit 140 may apply to each analogous embodiment in a corresponding manner, for example, to the third module string 148, the third connection string 146, the third current source 244, and the third sensor unit 256.

In an example, based on the previous explanations, during the first phase 158, for example, the first and third current sources 134, 244 may be simultaneously activated to generate the first and third currents, while the second and fourth current sources 152, 246 are deactivated during the first phase 158.

Further, the second module string 128, the second connection string 114, the second current source 152, and the second sensor unit 154 may be provided in an analogous manner multiple times, for example, by the fourth module string 248, the fourth connection string 252, the fourth current source 246, and the fourth sensor unit 258. The preceding explanations, potential features, technical effects, and advantages as explained in connection with the second module string 128, the second connection string 114, the second current source 152, and the second sensor unit 154 may apply to each analogous embodiment in a corresponding manner, for example, to the fourth module string 248, the fourth connection string 252, the fourth current source 246, and the fourth sensor unit 258.

In an example, based on the previous explanations, during the second phase 160, for example, the second and fourth current sources 152, 246 may be simultaneously activated to generate the second and fourth currents, while the first, third and fifth current sources 134, 244, 204 are deactivated during the second phase 160.

Figures 1 and 2 also each schematically illustrate an example of a system 170. The system 170 comprises the module 100 and the battery 106. In the system 170, the first module terminal 102 is coupled to the first battery node 104 via the first connection string 108. In the system 170, the second module terminal 110 is coupled to the second battery node 112 via the second connection string 114. In addition, the third module terminal 142 may be coupled to the third battery node 144 via the third connection string 146. Corresponding connection strings 252, 254 may be provided for additional module nodes of the module 100. The system 170 may further comprise the circuit unit 220. Parts of the connection strings 108, 114, 146, 252, 254, 120 may be formed by the circuit unit 220. In the system, the module 100 and the circuit unit 220 may be integrally formed by a device 222 that is configured to be physically separate from the battery 106. However, the device 222 and the battery 106 are electrically coupled to each other by coupling strings 230, 232, 234.

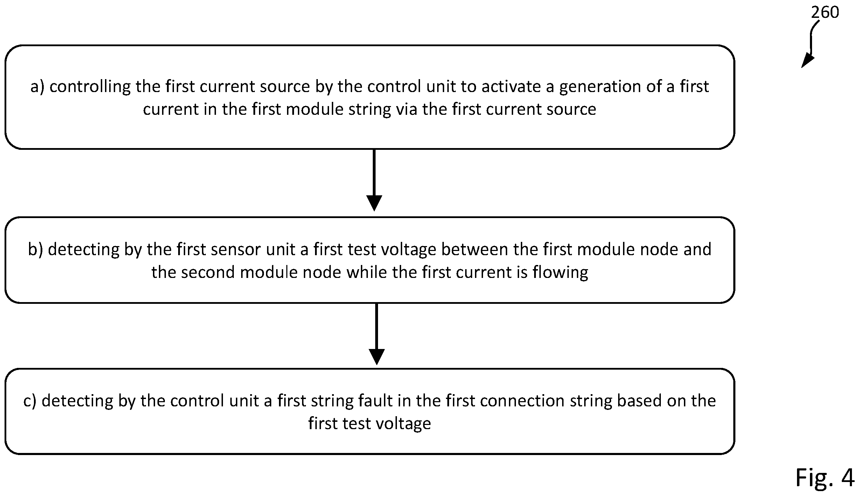

Figure 4 schematically illustrates an example of a method 260 for the module 100. The method 260 comprises the steps:
a) controlling the first current source by the control unit to activate a generation of a first current in the first module string via the first current source,
b) detecting by the first sensor unit a first test voltage between the first module node and the second module node while the first current is flowing, and
c) detecting by the control unit a first string fault in the first connection string based on the first test voltage.

The preceding explanations, potential features, technical effects and advantages as explained in connection with the module 100, the device 222 and/or the system 170 may apply in an analogous manner to the method 260.

Although the described exemplary embodiments disclosed herein focus on devices, systems, and methods for using same, the present disclosure is not necessarily limited to the example embodiments illustrate herein.

The systems and methods described herein may at least partially be embodied by a computer program or a plurality of computer programs, which may exist in a variety of forms both active and inactive in a single computer system or across multiple computer systems. For example, they may exist as software program(s) comprised of program instructions in source code, object code, executable code or other formats for performing some of the steps. Any of the above may be embodied on a computer-readable medium, which may include storage devices and signals, in compressed or uncompressed form.

As used herein, the term "computer" refers to any electronic device comprising a processor, such as a general-purpose central processing unit (CPU), a specific-purpose processor or a microcontroller. A computer is capable of receiving data (an input), of performing a sequence of predetermined operations thereupon, and of producing thereby a result in the form of information or signals (an output). Depending on the context, the term "computer" will mean either a processor in particular or more generally a processor in association with an assemblage of interrelated elements contained within a single case or housing.

The term "processor" or "processing unit" refers to a data processing circuit that may be a microprocessor, a co-processor, a microcontroller, a microcomputer, a central processing unit, a field programmable gate array (FPGA), a programmable logic circuit, and/or any circuit that manipulates signals (analog or digital) based on operational instructions that are stored in a memory. The term "memory" refers to a storage circuit or multiple storage circuits such as read-only memory, random access memory, volatile memory, non-volatile memory, static memory, dynamic memory, Flash memory, cache memory, and/or any circuit that stores digital information.

As used herein, a "computer-readable medium" or "storage medium" may be any means that can contain, store, communicate, propagate, or transport a computer program for use by or in connection with the instruction execution system, apparatus, or device. The computer-readable medium may be, for example but not limited to, an electronic, magnetic, optical, electromagnetic, infrared, or semiconductor system, apparatus, device, or propagation medium. More specific examples (non-exhaustive list) of the computer-readable medium may include the following: an electrical connection having one or more wires, a portable computer diskette, a random-access memory (RAM), a read-only memory (ROM), an erasable programmable read-only memory (EPROM or Flash memory), an optical fiber, a portable compact disc read-only memory (CDROM), a digital versatile disc (DVD), a Blu-ray disc (BD), and a memory card.

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

Unless stated otherwise, terms such as "first" and "second" are used to arbitrarily distinguish between the elements such terms describe. Thus, these terms are not necessarily intended to indicate temporal or other prioritization of such elements.

## Claims

1. A module comprising:
a first module terminal for coupling to a first battery node of a battery via a first connecting string,
a second module terminal for coupling to a second battery node of the battery via a second connection string,
a base module terminal for coupling to a base battery node of the battery via a base connection string,
wherein a first module string of the module extends from the first module terminal to a first module node of the module, wherein a first impedance is integrated into the first module string,
wherein a second module string of the module extends from the second module terminal to a second module node of the module, wherein a second impedance is integrated into the second module string,
wherein a first current source is coupled between the base module terminal and the first module node,
wherein a control unit of the module is coupled to the first current source and is configured to control the first current source to activate a generation of a first current in the first module string via the first current source,
wherein a first sensor unit of the module is coupled to the first and second module nodes,
wherein the first sensor unit is configured to detect a first test voltage between the first module node and the second module node while the first current is flowing, and
wherein the control unit is configured to detect a first string fault in the first connection string based on the first test voltage.

2. The module according to the preceding claim, wherein the control unit is configured to control the first current source to enable or disable the generation of the first current in the first module string via the first current source, wherein the first sensor unit is configured to detect a first circuit voltage between the first module node and the second module node while the first current is not flowing, and wherein the control unit is configured to detect the first string fault based on the first circuit voltage and the first test voltage.

3. The module according to the preceding claim, wherein the control unit is configured to detect the first string fault based on a first differential voltage representing a difference between the first circuit voltage and the first test voltage.

4. The module according to the preceding claim, wherein the control unit is configured to check whether the first differential voltage is outside a predefined first reference range, and wherein the control unit is configured to detect the first string fault in response to the first differential voltage being outside the first reference range.

5. The module according to any of the preceding claims, wherein the module comprises a third module terminal for coupling to a third battery node of the battery via a third connection string, wherein a third module string of the module extends from the third module terminal to a third module node of the module, wherein a third impedance is integrated into the third module string, wherein a second current source is coupled between the base module terminal and the second module node, wherein the control unit is coupled to the second current source and is configured to control the second current source to activate a generation of a second current in the second module string via the second current source, wherein a second sensor unit of the module is coupled to the second and third module nodes, wherein the second sensor unit is configured to detect a second test voltage between the second and third module nodes while the second current is flowing, and wherein the control unit is configured to detect a second string fault in the second connection string based on the second test voltage.

6. The module according to the preceding claim, wherein the control unit is configured to control the second current source to enable or disable the generation of the second current in the second module string via the second current source, wherein the second sensor unit is configured to detect a second circuit voltage between the second module node and the third module node while the second current is not flowing, and wherein the control unit is configured to detect the second string fault based on the second circuit voltage and the second test voltage.

7. The module according to the preceding claim, wherein the control unit is configured to detect the second string fault based on a second differential voltage representing a difference between the second circuit voltage and the second test voltage.

8. The module according to the preceding claim, wherein the control unit is configured to check whether the second differential voltage is outside a predefined second reference range, and wherein the control unit is configured to detect the second string fault in response to the second differential voltage being outside the second reference range.

9. The module according to any of the preceding claims, if also depending on claim 5, wherein the control unit is configured, in a first phase, to control the first current source to enable the generation of the first current in the first module string via the first current source, and, in the first phase, to control the second current source to disable the generation of the second current in the second module string via the second current source, and wherein the control unit is configured to control, in a second phase, the first current source to deactivate the generation of the first current in the first module string via the first current source, and to control, in the first phase, the second current source to activate the generation of the second current in the second module string via the second current source.

10. The module according to the preceding claim, if also depending on claims 2 and 6, wherein the control unit is configured, in a third phase, to control the first current source to deactivate the generation of the first current in the first module string via the first current source, and, in the third phase, to control the second current source to deactivate the generation of the second current in the second module string via the second current source, wherein the first sensor unit is configured to detect the first circuit voltage in the third phase, and wherein the second sensor unit is configured to detect the second circuit voltage in the third phase.

11. A system comprising:
a module according to any of the preceding claims,
a battery,
wherein the battery comprises a plurality of battery cells coupled in series between a first battery terminal and a second battery terminal,
wherein a first battery cell is coupled between the first battery node of the battery and the second battery node of the battery,
wherein a second battery cell of the battery is coupled between the second battery node and the third battery node of the battery,
wherein the first module terminal of the module is coupled to the first battery node via the first connection string, and
wherein the second module terminal of the module is coupled to the second battery node via the second connection string.

12. The system according to the preceding claim, wherein a sixth impedance is integrated into the first connection string, and wherein a seventh impedance is integrated into the second connection string.

13. The system according to the preceding claim, wherein the base module terminal of the module is coupled to the second battery terminal.

14. The system according to the preceding claim, if also depending on claim 5, wherein the third module terminal of the module is coupled to the third battery node via the third connection string, wherein an eighth impedance is integrated into the third connection string.

15. A method for a module, which comprises a first module terminal for coupling to a first battery node of a battery via a first connecting string, a second module terminal for coupling to a second battery node of the battery via a second connection string, a base module terminal for coupling to a base battery node of the battery via a base connection string, wherein a first module string of the module extends from the first module terminal to a first module node of the module, wherein a first impedance is integrated into the first module string, wherein a second module string of the module extends from the second module terminal to a second module node of the module, wherein a second impedance is integrated into the second module string, wherein a first current source is coupled between the base module terminal and the first module node, wherein a control unit of the module is coupled to the first current source, wherein a first sensor unit of the module is coupled to the first and second module nodes, and wherein the method comprises the steps:
a) controlling the first current source by the control unit to activate a generation of a first current in the first module string via the first current source,
b) detecting by the first sensor unit a first test voltage between the first module node and the second module node while the first current is flowing, and
c) detecting by the control unit a first string fault in the first connection string based on the first test voltage.
